(19) Europäisches Patentamt / European Patent Office / Office européen des brevets

(11) **EP 2 527 822 A1**

(12) **EUROPEAN PATENT APPLICATION**
published in accordance with Art. 153(4) EPC

(43) Date of publication:
**28.11.2012 Bulletin 2012/48**

(51) Int Cl.:
*G01N 23/04* *(2006.01)*    *G01B 15/00* *(2006.01)*

(21) Application number: **10843824.3**

(22) Date of filing: **30.03.2010**

(86) International application number:
**PCT/JP2010/002320**

(87) International publication number:
**WO 2011/089658 (28.07.2011 Gazette 2011/30)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **19.01.2010 JP 2010009344**

(71) Applicant: **Saki Corporation
Shinagawa-ku, Tokyo 142-0053 (JP)**

(72) Inventors:
• **WADA, Takahiko**
  **Tokyo 142-0053 (JP)**
• **HIRAYAMA, Takuma**
  **Tokyo 142-0053 (JP)**

(74) Representative: **Algemeen Octrooi- en
Merkenbureau
P.O. Box 645
5600 AP Eindhoven (NL)**

(54) **METHOD FOR CORRECTING INSPECTING APPARATUS USING CORRECTING JIG, AND INSPECTING APPARATUS HAVING CORRECTING JIG MOUNTED THEREON**

(57)    A holding unit (24) fixes an object to be inspected formed integrally with a jig (42). A detection unit (26) creates a transmission image by detecting a radiation ray passing through the object to be inspected or the jig (42). A deviation amount specification unit (36) acquires the transmission image of the jig (42) to specify a characteristic point of the jig (42) photographed on the transmission image, and calculates an amount of deviation between the characteristic point of the jig (42) photographed on the transmission image and the center of the whole transmission image. An imaging control unit (40) corrects a positional relationship between the object to be inspected and the detection unit (26) for acquiring a transmission image based on the amount of deviation.

**Description**

Field of the Invention

The present invention relates to a method of correcting an inspection apparatus by using a correction jig for an inspection apparatus and to a correction apparatus in which the correction jig is mounted.

Background Art

Examples of a substrate on which an electronic component is mounted (hereinafter, referred to as a "substrate") include a substrate on which a BGA (Ball Grid Array)is mounted and a substrate on which an LGA (Land Grid Array) is mounted. In these substrates, a terminal, which is an electrical connection portion of a component, is located between the substrate and the component, and it is difficult to observe, by a conventional visual inspection apparatus using a camera, the state of a solder for joining the component and the substrate. Accordingly, a technique is presented, in which the three-dimensional shape of a solder in a joint portion is reconstructed into an image based on transmission images of the solder obtained by radiating X-rays onto a substrate from multiple different directions such that the inspection is performed by using a cross-sectional image in which any cross-section of the solder has been cut out (see Patent Document 1).

[Patent Document]

[Patent Document 1] Japanese Patent Application Publication No. 2006-226875.

DISCLOSURE OF THE INVENTION

Problem to be Solved by the Invention

There are various techniques for reconstructing the three-dimensional shape of an object to be inspected from transmission images of the object to be inspected, in most of which geometric positional relationships in an imaging system for taking the transmission images, such as the distance between the object to be inspected and an X-ray radiation unit, an radiation angle, and the distance between the object to be inspected and an X-ray detector, are needed. In such a case, a geometric positional relationship supposed by a technique is made to be matched to that in an actual imaging system; however, complicated procedures, such as measurement of the positional relationship while halting an inspection process, are needed for achieving the matching. In addition, it is needed to make a variation in the outputs of a plurality of radiation ray light receiving elements of which an X-ray detector is composed to be small.
The present invention has been made in view of these situations, and a purpose of the invention is to provide a means for simply correcting an imaging system in an inspection apparatus.

Means for Solving the Problem

An embodiment of the present invention relates to a method of correcting an inspection apparatus. This method comprises performing image analysis of a transmission image taken with a jig being an object to be inspected to specify a characteristic point of the jig photographed on the transmission image, so that a positional relationship between a radiation ray detector for acquiring a transmission image and the object to be inspected is corrected based on an amount of deviation between the characteristic point of the jig photographed on the transmission image and the center of the whole transmission image.
Another embodiment of the present invention relates to an inspection apparatus. This apparatus comprises: a holding unit formed integrally with a jig, configured to fix an object to be inspected; a detection unit configured to create a transmission image by detecting a radiation ray passing through the object to be inspected or the jig; and a drive unit configured to correct a positional relationship between the object to be inspected and a radiation ray detector for acquiring a transmission image by transferring the holding unit based on an amount of deviation calculated from both a characteristic point of the jig photographed on the transmission image of the jig and the center of the whole transmission image.
Still another embodiment of the present invention also relates to an inspection apparatus. This apparatus comprises: a holding unit formed integrally with a jig, configured to fix an object to be inspected; a detection unit configured to create a transmission image by detecting a radiation ray passing through the object to be inspected or the jig; a deviation amount specification unit configured to acquire a transmission image of the jig to specify a characteristic point of the jig photographed on the transmission image, and to calculate an amount of deviation between the characteristic point of the jig photographed on the transmission image and the center of the whole transmission image; and an imaging control unit configured to correct a positional relationship between the object to be inspected and a radiation ray detector for acquiring a transmission image based on the amount of deviation.

It is noted that any combination of the aforementioned components or any manifestation of the present invention exchanged between methods, devices, systems computer programs, data structures, and recording media, and so forth, is also effective as an embodiment of the present invention.

Advantage of the Invention

According to the present invention, a means for simply correcting an imaging system in an inspection apparatus can be provided.

BRIEF DESCRIPTION OF THE DRAWINGS

Fig. 1 is a view schematically illustrating the configuration of a radiation ray inspection apparatus according to an embodiment of the present invention;
Fig. 2 is a view illustrating each of functional blocks by which a PC according to Embodiment 1 performs processing;
Fig. 3 is a flowchart illustrating the flow of processing for adjusting the position of a substrate holding unit by using a correction jig according to Embodiment 1;
Fig. 4 is a view schematically illustrating the geometric positional relationship among a radiation ray generator, the substrate holding unit, and a detector according to Embodiment 1;
Fig. 5 is a view schematically illustrating the external appearance of the substrate holding unit part of which including the correction jig;
Fig. 6 is a flowchart explaining the flow of processing for updating a center correction amount, taking advantage of a spare time between inspections;
Fig. 7 is a view schematically illustrating the positional relationship between a radiation ray source and an attention point on the detector;
Fig. 8 is a graph schematically showing the relationship between a radiation ray radiated onto the detector and the pixel value of a transmission image at the time;
Fig. 9 is a graph schematically showing a correction table for a pixel value described with reference to Fig. 8;
Fig. 10 is a view illustrating each of functional blocks by which a PC according to Embodiment 2 performs processing; and
Fig. 11 is a flowchart illustrating the flow of the creation of a correction table according to Embodiment 2.

BEST MODE FOR CARRYING OUT THE INVENTION

(Embodiment 1)

Outline of Embodiment 1 according to the present invention will be described. In Embodiment 1, a correction jig is installed in a substrate holding unit to image it at the center of a detector such that a transmission image thereof is taken, and an amount of deviation between the center of the imaged correction jig and the center of the transmission image is measured. The position of the correction jig is corrected by calculating a correction amount of the installation position of the correction jig in the substrate holding unit based on the geometric positional relationship in an imaging system at the imaging time and then by transferring the substrate holding unit.

Fig. 1 is a view schematically illustrating a radiation ray inspection apparatus 100 according to the embodiment. The radiation ray inspection apparatus 100 comprises a PC (Personal Computer) 10, a monitor 12, and an imaging unit 32. The imaging unit 32 further includes a radiation quality modification unit 14, a radiation ray generator drive unit 16, a substrate holding unit drive unit 18, a detector drive unit 20, a radiation ray generator 22, a substrate holding unit 24, and a detector 26.

The radiation ray generator 22 functions to generate a radiation ray, such as an X-ray, by making an accelerated electron hit a target, such as tungsten or diamond.

The substrate holding unit 24 holds a substrate, an object to be inspected. Radiation rays generated by the radiation ray generator 22 are radiated onto the substrate held by the substrate holding unit 24 such that the radiation rays passing through the substrate are photographed as an image by the detector 26. Hereinafter, a radiation ray transmission image of the substrate photographed by the detector 26 is referred to as a "transmission image".

The transmission image is sent to the PC 10 to be reconstructed into an image including a three-dimensional shape of solder in a joint portion by using a known technique, such as, for example, a Filtered-Backprojection (FBP) method. The reconstructed image or transmission image is stored in a storage in the PC 10 or in a non-illustrated external storage. Hereinafter, an image that has been reconstructed, based on the transmission image, into a three-dimensional image including a three-dimensional shape of the solder in a solder portion is referred to as a "reconstructed image". An image in which an arbitrary cross-section cut out from the reconstructed image is photographed is referred to as a "cross-sectional image". The reconstructed image and the cross-sectional image are outputted to the monitor 12. The monitor 12 displays results of inspecting a joint state of solder, which will de described later, in addition to the reconstructed image and the cross-sectional image.

The radiation quality modification unit 14 modifies the quality of a radiation ray generated by the radiation ray generator 22. The quality of a radiation ray is determined by a voltage to be applied for accelerating an electron that is made to hit a target (hereinafter, referred to as a "tube voltage") or a current by which the number of electrons is determined (hereinafter, referred to as a "tube current"). The radiation quality modification unit 14 functions to control these tube voltage and tube current. This control can be achieved by using a known technique, such as a transformer, or a rectifier.

Herein, the quality of a radiation ray is determined by the luminance and hardness of the radiation ray (spectrum distribution of the radiation ray). As a tube current is made larger, the number of electrons that hit a target becomes larger, thereby increasing the number of photons of a generated radiation ray. As a result, the luminance of the radiation ray becomes large. Some of components, such as, for example, capacitors, have a larger thickness than that of other components, and hence it is needed to radiate a radiation ray having a large luminance for taking a transmission image of these components. In such a case, the luminance of the radiation ray is adjusted by adjusting a tube current. In addition, as a tube voltage is made larger, the energy of an electron that hits a target becomes larger, thereby increasing the energy (spectrum) of a generated radiation ray. As the energy of a radiation ray becomes larger, the penetrating power thereof at which the radiation ray passes through a substance generally becomes larger, thereby allowing the radiation ray to be more resistant to being absorbed by the substance. The contrast of a transmission image taken by using such a radiation ray becomes small. Accordingly, a tube voltage can be used for adjusting the contrast of a transmission image.

The radiation ray generator drive unit 16 has a non-illustrated drive mechanism, such as a motor, and hence the radiation ray generator 22 can be transferred up and down along an axis passing through the focus of the generator 22. Thereby, a radiation field can be changed by changing the distance between the radiation ray generator 22 and an object to be inspected that is held by the substrate holding unit 24, thereby allowing a magnification of a transmission image taken by the detector 26 to be changed.

The detector drive unit 20 also has a non-illustrated drive mechanism, such as a motor, and hence the detector 26 can be rotationally transferred along a detector rotational trajectory 30. The substrate holding unit drive unit 18 also has a non-illustrated drive mechanism, such as a motor, and hence the substrate holding unit 24 can be parallel transferred on the plane made by a substrate rotational trajectory 28. The substrate holding unit 24 is configured to be rotationally transferred on the substrate rotational trajectory 28 simultaneously as the detector 26 is rotationally transferred. Thereby, a transmission image can be taken while changing the relative positional relationship between the substrate held by the substrate holding unit 24 and the radiation ray generator 22.

Herein, the turning radius of each of the substrate rotational trajectory 28 and the detector rotational trajectory 30 is not fixed, but is configured to be freely changed. Thereby, a radiation angle of a radiation ray at which the radiation ray is radiated onto a component arranged on the substrate can be changed.

The PC 10 controls the whole operations of the aforementioned radiation ray inspection apparatus 100. Although not illustrated in the view, input devices, such as a key board and a mouse, and a communication interface, such as a LAN, are connected to the PC 10.

Fig. 2 is a view illustrating each of functional blocks by which the PC 10 according to Embodiment 1 performs processing. The PC 10 includes a recording unit 34, a deviation amount specification unit 36, a correction amount calculation unit 38, and an imaging control unit 40.

The recording unit 34 stores a transmission image of the correction jig on the substrate holding unit 24, which has been acquired from the detector 26, etc. The deviation amount specification unit 36 acquires a transmission image of the correction jig from the recording unit 34 to specify an amount of deviation between the center of the correction jig photographed on the transmission image and the center of the transmission image. The correction amount calculation unit 38 acquires both the geometric positional relationship in the current imaging system from the imaging control unit 40 and an amount of deviation from the deviation amount specification unit 36, and calculates, based on these information, a correction amount by which the correction jig is to be deviated in order to photograph the center of the correction jig at the center of the transmission image (hereinafter, referred to as a "center correction amount").

The imaging control unit 40 directs the radiation quality modification unit 14 to change a tube voltage and a tube current, and takes transmission images necessary for the creation of a reconstructed image by controlling the radiation ray generator drive unit 16, the substrate holding unit drive unit 18, and the detector drive unit 20. Also, the imaging control unit 40 adjusts, in accordance with the center correction amount calculated by the correction amount calculation unit 38, the position of the substrate holding unit 24 via the substrate holding unit drive unit 18.

Each of the aforementioned functional blocks is achieved by the cooperation of hardware, such as a CPU executing various arithmetic processing and a RAM used as a work area for storing data and executing programs, and software. Accordingly, these functional blocks can be achieved in various forms by combining hardware and software.

Fig. 3 is a flowchart illustrating the flow of processing for adjusting the position of the substrate holding unit by using the correction jig according to Embodiment 1. The processing in this flowchart is initiated when the deviation amount specification unit 36 acquires a transmission image of the correction jig.

The deviation amount specification unit 36 acquires a transmission image of the correction jig from the recording unit 34 (S10). The deviation amount specification unit 36 then specifies the center of the correction jig photographed on the transmission image, and specifies an amount of deviation with the center of the transmission image (S12). When the amount of deviation exceeds a preset acceptable range (S14N), the correction amount calculation unit 38 acquires both the geometric positional relationship in the current imaging system from the imaging control unit 40 and an amount of deviation from the deviation amount specification unit 36, and calculates, based on these information, a center correction amount (S16). The imaging control unit 40 adjusts, in accordance with the center correction amount calculated by the correction amount calculation unit 38, the position of the substrate holding unit 24 via the substrate holding unit drive unit 18 (S18).

When a transmission image of the correction jig is taken again and an amount of deviation in Step S12 is within the preset acceptable range after the position of the substrate holding unit 24 has been adjusted (S14Y), the processing in the present flowchart is ended.

Fig. 4 is a view schematically illustrating the geometric positional relationship among the radiation ray generator, the substrate holding unit 24, and the detector 26.

The rotational center of the detector rotational trajectory 30 is made to be the original point O (0, 0, 0) and a straight line that passes through the original point O and is perpendicular to a plane on which the detector rotational trajectory 30 is present is determined as a Z-axis. In this case, because a radiation ray source of the radiation ray generator 22 exists on the Z axis, the coordinate of the point is made to be $(0, 0, Z_t)$. Because the rotational center of the substrate rotational trajectory 28 also exists on the Z axis, the coordinate of the point is made to be $(0, 0, Z_s)$.

It is assumed that a jig whose transmission image has a circular shape is used as the correction jig. This corresponds to such a case where, for example, when a metal plate having a square shape is prepared and a circularly-shaped hole whose center is at the intersection of the diagonal lines of the square shape is opened, a transmission image of the metal plate has a circular shape whose center is at the intersection of the diagonal lines of the square shape.

The correction jig is installed in the substrate holding unit 24 such that the center of the circle is on the substrate rotational trajectory 28. In the case, the coordinate of the center of the circle is made to be $(X_s, Y_s, Z_s)$. When the ratio of the turning radius of the substrate rotational trajectory 28 to that of the detector rotational trajectory 30 is made to be $Z_s : Z_t$, the center of the circle that is a transmission image of the correction jig should be at the center of the transmission image if the center of the detector 26 is on the detector rotational trajectory 30.

In the aforementioned relationship, the center of the circle whose coordinate is $(X_s, Y_s, Z_s)$ is projected, on the X-Y plane, at a point whose coordinate is represented by Expression 1:

[Expression 1]

$$\left( \frac{Z_t}{Z_s} X_s, \frac{Z_t}{Z_s} Y_s, 0 \right)$$

Because the center of the transmission image is at the center of the detector, an amount of deviation $\delta_x$ in the X-axis direction and an amount of deviation $\delta_y$ in the Y-axis direction are represented by Expression 2 when the center of the transmission image is made to be $(X_D, Y_D, 0)$:

[Expression 2]

$$\left(\delta_X, \delta_Y\right) = \left( X_D - \frac{Z_t}{Z_s} X_s, Y_D - \frac{Z_t}{Z_s} Y_s \right)$$

Accordingly, when the substrate holding unit 24 that holds the correction jig is shifted by the amounts represented by Expression 3 in the X-direction and Y-direction, respectively, the center of the circle that is a transmission image of the correction jig is at the center of the transmission image:

[Expression 3]

$$\left( -\frac{Z_s}{Z_t} \delta_X, -\frac{Z_s}{Z_t} \delta_Y \right) = \left( X_s - \frac{Z_s}{Z_t} X_D, Y_s - \frac{Z_s}{Z_t} Y_D \right) \qquad (1)$$

Therefore, the center correction amount is represented by Equation (1).

Accordingly, the deviation amount specification unit 36 specifies, by image analysis, the center of the circle that is a transmission image of the correction jig in order to specify the amounts of deviation $\delta_x$ and $\delta_y$ from the center of the transmission image. The correction amount calculation unit 38 acquires, from the imaging control unit 40, the Z coordinate of the radiation ray generator 22, the coordinate of the center of the substrate holding unit 24, and the coordinate of the center of the detector 26 in order to calculate a center correction amount based on the aforementioned Equation (1). The imaging control unit 40 acquires the center correction amount calculated by the correction amount calculation unit 38 in order to correct the position of the substrate holding unit 24 via the substrate holding unit drive unit 18. The imaging control unit 40 stores the center correction amount in the recording unit 34.

In order to reconstruct a cross-sectional image of a substrate, it is needed to acquire transmission images of the substrate by radiating X-rays onto the substrate from multiple different directions. To achieve that, transmission images are acquired by rotating the substrate holding unit 24 and the detector 26. Accordingly, the aforementioned center correction amounts are determined in multiple points on the rotational trajectory. A center correction amount once determined is stored in the recording unit 34, and the center correction amount stored in the recording unit 34 is read out for the adjustment before the center correction amount is updated.

Fig. 5 is a view schematically illustrating the external appearance of the substrate holding unit 24 part of which including the correction jig 42. The substrate holding unit 24 and the correction jig 42 are integrated together by installing the correction jig 42 adjacently to the substrate holding unit 24. As stated above, the substrate holding unit 24 can be parallel transferred on the plane made by the substrate rotational trajectory 28. Accordingly, as usual during inspection, inspection is performed with an object to be inspected being held by the substrate holding unit 24; and when it is needed to correct the position of the substrate holding unit 24, the substrate holding unit 24 is parallel transferred on the plane made by the substrate rotational trajectory 28 before the correction jig 42 is on the substrate rotational trajectory 28.

By forming the substrate holding unit 24 and the correction jig 42 to be integrated with each other, as stated above, a process for installing, in advance of the calculation of the center correction amount, the correction jig 42 in the substrate holding unit 24 can be omitted. There are many cases where the inspection apparatus according to Embodiment 1 is installed in an unmanned production line. The omission of the process for installing the correction jig 42 can save not only the time necessary for the installation, but also the time and expenses of an engineer travelling for the apparatus, thereby possibly enabling a great reduction in cost.

Further, by using the aforementioned technique for calculating a center correction amount, it becomes possible to update a center correction amount, taking advantage of a spare time between inspections. Accordingly, an average time required for calculating a center correction amount is stored in the recording unit 34 in advance in order to determine whether a spare time between inspections is longer than or equal to the time required for calculating a center correction amount. This determination is made by the deviation amount specification unit 36. Alternatively, a non-illustrated dedicated configuration, such as a center correction amount update start determination unit, may be provided.

Fig. 6 is a flowchart for explaining the flow of processing for updating a center correction amount, taking advantage of a spare time between inspections. The processing in this flowchart is initiated when, for example, a predetermined spare time is generated between inspections.

With reference to the inspection schedule stored in the recording unit 34 in advance, the deviation amount specification unit 36 determines that, when there is a spare time between inspections that is long enough for calculating a center correction amount, the center correction amount should be updated at the time (S20). Alternatively, the deviation amount specification unit 36 acquires, from an operator via a non-illustrated user interface, such as a key board or a LAN, a timing when a center correction amount is updated.

The deviation amount specification unit 36 then calculates, from the spare time between inspections acquired from the recording unit 34, how many places of center correction amounts can be updated, i.e., the number of update times. Also, the deviation amount specification unit 36 specifies, in the order from the oldest to the newest update, N places of the center correction amounts stored in the recording unit 34 (S22). Alternatively, the deviation amount specification unit 36 acquires, from an operator, a place where the center correction amount is to be updated.

The deviation amount specification unit 36 sets a loop variable i in a non-illustrated internal work memory and initializes the loop variable i with 1 (S24). Herein, the loop variable i is used for performing N times of update, which is specified as the number of times for updating center correction amounts.

When the loop variable i is smaller than or equal to N (S26Y), the deviation amount specification unit 36 acquires a transmission image of the correction jig 42 stored in the recording unit 34 after being taken and determines the aforementioned amount of deviation $\delta_x$ in the X-axis direction and amount of deviation $\delta_y$ in the Y-axis direction; while the correction amount calculation unit 38 acquires, from the imaging control unit 40, the Z coordinate of the radiation ray generator 22, the coordinate of the center of the substrate holding unit 24, and the coordinate of the center of the detector 26 to calculate a center correction amount based on the aforementioned Equation (1) (S28). The imaging control unit 40 acquires the center correction amount calculated by the correction amount calculation unit 38 to correct the position of the substrate holding unit 24 via the substrate holding unit drive unit 18 (S30). When a center correction amount is stored in the recording unit 34 by the imaging control unit 40, the deviation amount specification unit 36 updates the loop variable i with i+1 (S32), and continues the update of a center correction amount. When the loop variable i becomes larger than N (S26N), the processing in this flowchart is ended.

Operations of the aforementioned configuration will be described as follows. A user installs the inspection apparatus according to Embodiment 1 in a production line. When a predetermined spare time is generated between inspections, the inspection apparatus acquires a transmission image of the correction jig 42 provided side-by-side with the substrate holding unit 24 to calculate a center correction amount based on the aforementioned Equation (1). The position of the substrate holding unit 24 is corrected based on the calculated center correction amount, and the center correction amount is stored in the inspection apparatus. Because center correction amounts are updated in the order from the oldest to the newest update, the geometric positions in the imaging system in the inspection apparatus are properly corrected as a whole.

As stated above, according to Embodiment 1, it becomes possible to automatically measure and correct an amount of deviation between the geometric positional relationship in an imaging system, the geometric positional relationship being supposed by an algorithm for reconstructing a three-dimensional shape of an object to be inspected from the transmission images of the object to be inspected, and the geometric positional relationship in an actual imaging system. Further, by forming the holding unit of a substrate, which is an object to be inspected, and a correction jig used for estimating an amount of deviation to be integrated with each other, a process for installing a correction jig can be omitted in measuring an amount of deviation. By using both a technique for automatically correcting an amount of deviation and a holding unit of a substrate with which a correction jig has been integrated, an amount of deviation with an imaging system can be automatically corrected within a spare time between inspections.

(Embodiment 2)

Outline of Embodiment 2 will be described. Embodiment 2 relates to correction of a detector. The pixel value of a transmission image created when a radiation ray is not radiated at all onto the detector, is made to be 0, and the pixel value of a transmission image created when radiation rays are radiated until a level at which the dynamic range of the detector becomes a maximum, is made to be 100. In this case, a table is created by checking a variation in the pixel value with respect to a radiation amount of the radiation ray. The pixel value of a transmission image is corrected by using the table such that the relationship between the pixel value of the transmission image and the radiation amount of the radiation ray becomes linear. On the premise of that, the pixel value of a transmission image is corrected based on the distance between the detector and a radiation ray source in view of a phenomenon in which, when the respective distances between two arbitrary points on the radiation ray detector and the radiation ray source are different from each other, the radiation ray amounts reaching the points on the detector are different from each other because of attenuation of the radiation ray.

Hereinafter, a technique that is a premise of Embodiment 2 will be described. Duplicative descriptions of Embodiment 1 will be appropriately omitted.

Fig. 7 is a view schematically illustrating the positional relationship between the radiation ray generator 22 and an attention point 44 on the detector 26. In the same way as in Fig. 4, the rotational center of the detector rotational trajectory 30 is made to be the original point O (0, 0, 0), and a straight line that passes through the original point O and is perpendicular to a plane on which the detector rotational trajectory 30 is present is determined as a Z-axis. In this case, because a radiation ray source of the radiation ray generator 22 exists on the Z axis, the coordinate of the point is made to be (0, 0, $Z_t$).

The coordinate of the attention point 44 on the detector 26 is made to be ($X_D$, $Y_D$, 0). In this case, when the distance between the attention point 44 and the radiation ray generator 22 is made to be L, $L^2 = X_D^2 + Y_D^2 + Z_t^2$ holds. The radiation ray generator 22 is a point light source and an amount of light (including a radiation ray) radiated from a point light source is generally inversely proportional to square of the distance L from the point light source. Accordingly, a light amount of the radiation ray radiated from the radiation ray generator 22 is changed depending on the coordinate of the attention point 44 on the detector 26.

A light amount I of the radiation ray, which has been radiated from the radiation ray generator 22 and is detected at the attention point 44, is represented by I($X_D$, $Y_D$) as a function of X coordinate $X_D$ and Y coordinate $Y_D$ of the attention point 44. In this case, the following Equation (2) can be used for converting the light amount I received at the attention point 44 into a light amount I' received at the original point O (0, 0, 0).

[Equation 4]

$$I'(X_D, Y_D) = \frac{z_t^2}{L^2} I(X_D, Y_D) = \frac{z_t^2}{X_D^2 + Y_D^2 + z_t^2} I(X_D, Y_D) \qquad (2)$$

Fig. 8 is graph schematically showing the relationship between a radiation ray radiated onto the detector 26 and the pixel value of a transmission image at the time. An amount of the radiation ray received by the detector 26 is determined by an amount of photons that hit the detector 26. As a time during which the detector 26 is receiving radiation rays, i.e., a shutter time is made longer, an amount of the received radiation rays is increased. Also, when a tube current is increased, the density of photons per unit time is increased as described above, and hence an amount of the received radiation rays is increased even in the same shutter time. Accordingly, an amount of the radiation ray when the maximum radiation ray amount, which is acceptable for the dynamic range of the detector 26, is made to be 100% by changing a shutter time t or a tube current i, is set on the horizontal axis.

It is taken into consideration that, as an amount of the radiation ray received by the detector 26 is larger, a transmission image is created as a brighter image having a larger pixel value. If a pixel value is made to be 100 when a radiation ray amount is 100% and that is made to be 0 when a radiation ray amount is 0%, the relationship between a radiation ray amount and the pixel value of a transmission image becomes linear only when the relationship indicated by a dashed line 46 is satisfied.

A curve 48 is obtained by plotting the pixel values of a transmission image, occurring when the radiation ray amount is changed from 0 to 100 at intervals of 25 by controlling the shutter time t or the tube current i, and then by performing interpolation. In the example in Fig. 8, the curve 48 is located below the dashed line 46. This means that, when a radiation ray amount is X%, a pixel value should be X if the relationship between the radiation ray amount and the pixel value is linear, but the pixel value actually becomes a value smaller than X. Accordingly, when the pixel value is corrected by preparing a correction table by which the pixel value of a transmission image is made large, the relationship between the radiation ray amount and the pixel value of a transmission image can be converted into a linear one.

Fig. 9 is a graph schematically showing a correction table for a pixel value described with reference to Fig. 8. A curve 50 in the graph is a correction table obtained when the pixel value of a transmission image before correction is represented by the horizontal axis and the pixel value thereof after correction is represented by the vertical axis. The shape of the curve 50 represents an inverse function of the curve 48 in Fig. 8.

Fig. 10 illustrates each of functional blocks by which a PC 10 according to Embodiment 2 performs processing. The PC 10 includes the recording unit 34, an image correction unit 52, a correction table creation unit 54, and the imaging control unit 40.

The correction table creation unit 54 further includes a pixel value correction table creation unit 56 and a received light amount correction table creation unit 58. The received light amount correction table creation unit 58 creates a received light amount correction table by which an influence of attenuation of a radiation ray is corrected based on the aforementioned Equation (2). In Equation (2), the geometric positional relationship between the radiation ray generator 22 and the detector 26 is made to be a parameter. Accordingly, the received light amount correction table creation unit 58 creates a received light amount correction table in a form of the function of Equation (2) to which the positional coordinate $(X_D, Y_D)$ of each light receiving element in the detector 26 in the coordinate system in Fig. 7 is inputted, by acquiring, from the imaging control unit 40, the geometric positional relationship between the radiation ray generator 22 and the detector 26.

The pixel value correction table creation unit 56 creates a correction table by which the relationship between a radiation ray amount and the pixel value of a transmission image is made to be linear. Accordingly, the pixel value correction table creation unit 56 directs the imaging control unit 40 to radiate radiation rays from the radiation ray generator 22 at predetermined intervals of a radiation ray amount from 0% to 100%, to acquire the pixel values of transmission images at each time of the radiation in the case where an object to be inspected is not present. Subsequently, the pixel value correction table creation unit 56 interpolates data of the radiation ray amounts and the pixel values of transmission images by using a known interpolation technique, such as spline interpolation, to determine a curve representing the relationship between a radiation ray amount and the pixel value of a transmission image as shown by the curve 48 in Fig. 8. Finally, a pixel value correction table, by which the relationship between a radiation ray amount and the pixel value of a transmission image is made to be linear, is created by determining the inverse function of the determined curve.

The image correction unit 52 acquires a pixel value correction table and a received light amount correction table from the pixel value correction table creation unit 56 and the received light amount correction table creation unit 58, respectively. Hereinafter, a combination of a pixel value correction table and a received light amount correction table is sometimes referred to as a "correction table". The pixel value of a transmission image before correction stored in the recording unit 34 is corrected by using the acquired correction table, and the result is stored in the recording unit 34.

In order to reconstruct a cross-sectional image of a substrate, it is needed to acquire transmission images of the substrate by radiating X-rays onto the substrate from multiple different directions, as stated above. To achieve that, the pixel value correction table creation unit 56 creates a pixel value correction table at each position, while the substrate holding unit 24 and the detector 26 are being rotated by directing the imaging control unit 40. It becomes possible to swiftly perform the correction in an inspection process by creating, in advance, a pixel value correction table and a received light amount correction table with respect to each of the imaging conditions (geometric relationship in an imaging system, a volume of a tube current or a tube voltage) that are frequently used, and by storing them in the recording unit 34. In addition, in the same way as in Embodiment 1, the correction tables are updated in the order from the oldest to the newest creation time, when there is a predetermined spare time between inspections.

Fig. 11 is a flowchart illustrating the flow of the creation of a correction table according to Embodiment 2. The processing in this flowchart is initiated at a timing when, for example, a correction table is updated in a spare time between inspections.

The received light amount correction table creation unit 58 acquires geometric information on the current imaging system from the imaging control unit 40 (S34), to create a received light amount correction table based on the aforementioned Equation (2) (S36). The pixel value correction table creation unit 56 directs the imaging control unit 40 to change radiation rays from the radiation ray generator 22 at predetermined intervals of a radiation ray amount from 0% to 100% (S38). The pixel value correction table creation unit 56 acquires the pixel value of a transmission image of the correction jig 42, which has been taken and stored in the recording unit 34 (S40).

When a radiation ray amount is not moved to 100% and it is still needed to change a radiation ray amount (S42Y), the processing returns to Step S38 to continuously take transmission images. If the pixel value of a transmission image is acquired when a radiation ray amount is moved from 0% to 100% (S42N), the pixel value correction table creation unit 56 creates a pixel value correction table by determining the inverse function of a curve representing the relationship between a radiation ray amount and the pixel value of a transmission image (S44). When a correction table is not created with respect to every imaging condition to be determined (S46N), the pixel value correction table creation unit 56 sets a new imaging condition via the imaging control unit 40 (S48), to continue the creation of correction tables. When the correction table has been created with respect to every imaging condition to be determined (S46Y), the processing in this flowchart is ended.

Operations of the aforementioned configuration will be described as follows. A user installs the inspection apparatus according to Embodiment 2 in a production line. The inspection apparatus acquires a transmission image immediately after being activated or when a predetermined spare time is generated between inspections, to calculate a correction table based on the aforementioned Equation (2). The calculated correction table is stored in the inspection apparatus such that the image correction unit 52 corrects the pixel value of a transmission image at each time when a transmission image is taken. Because correction tables are updated in the order from the oldest to the newest update, the pixel values of transmission images in the inspection apparatus are properly corrected as a whole.

According to the Embodiment 2, a transmission image in which a variation in pixel values, occurring due to attenuation of a radiation ray, has been corrected can be acquired, as stated above. Further, a transmission image in which the relationship between the pixel value of a transmission image and the radiation amount of a radiation ray is linear can be acquired. Furthermore, a correction table necessary for acquiring such a transmission image can be automatically acquired, taking advantage of a spare time between inspections.

Embodiments 1 and 2 have been described above. Any combination of these embodiments is also effective as an embodiment of the present invention. When a correction table is made to be created, by combining Embodiment 1 and Embodiment 2, in an inspection apparatus comprising the substrate holding unit 24 integrated with the correction jig 42, a center correction amount can be calculated by using a transmission image of the correction jig 42 whose pixel value has been properly corrected, in addition to the total of the advantages of Embodiments 1 and 2, and hence it is advantageous in terms of allowing the accuracy in calculating a center correction amount to be further improved.

The present invention has been described above based on preferred embodiments. The embodiments have been described for exemplary purpose only, and it can be readily understood by a person skilled in the art that various modifications may be made by making various combinations of the aforementioned components or processes, which are also encompassed in the scope of the present invention.

In the aforementioned Embodiment 1, the case where the imaging control unit 40 corrects, by acquiring the center correction amount calculated by the correction amount calculation unit 38, the position of the substrate holding unit 24 via the substrate holding unit drive unit 18 has been described; however, the imaging control unit 40 may correct the position of the detector 26.

In the aforementioned Embodiment 1, the case where a jig whose transmission image has a circular shape is used as a correction jig has been described; however, a correction jig is not limited to one whose transmission image has a circular shape, but any correction jig whose transmission image has a shape having any characteristic point may be used. The characteristic point means a point in a shape photographed on a transmission image, which can be specified by image analysis. For example, the end point of a line segment, the angle of a broken line, the intersection of two or more line segments, the tip of an arrow, the rotational center in the case of a figure symmetric with respect to a point, or the center of gravity of any figure, is exemplified as the characteristic point. In this case, the deviation amount specification unit 36 performs image analysis in accordance with the characteristic point.

Reference Numerals

| | |
|---|---|
| 10 | PC |
| 18 | SUBSTRATE HOLDING UNIT DRIVE UNIT |
| 20 | DETECTOR DRIVE UNIT |
| 22 | RADIATION RAY GENERATOR |
| 24 | SUBSTRATE HOLDING UNIT |
| 26 | DETECTOR |
| 28 | SUBSTRATE ROTATIONAL TRAJECTORY |
| 30 | DETECTOR ROTATIONAL TRAJECTORY |
| 34 | RECORDING UNIT |
| 36 | DEVIATION AMOUNT SPECIFICATION UNIT |
| 38 | CORRECTION AMOUNT CALCULATION UNIT |
| 40 | IMAGING CONTROL UNIT |
| 42 | CORRECTION JIG |
| 52 | IMAGE CORRECTION UNIT |
| 54 | CORRECTION TABLE CREATION UNIT |
| 56 | PIXEL VALUE CORRECTION TABLE CREATION UNIT |
| 58 | RECEIVED LIGHT AMOUNT CORRECTION TABLE CREATION UNIT |
| 100 | RADIATION RAY INSPECTION APPARATUS |

Industrial Applicability

The present invention can be used for correcting an inspection apparatus by using a correction jig for inspection apparatuses and for an inspection apparatus in which the correction jig is mounted.

**Claims**

**1.** A method of correcting an inspection apparatus (100), comprising:

performing image analysis of a transmission image taken with a jig (42) being an object to be inspected to specify a characteristic point of the jig (42) photographed on the transmission image, so that a positional relationship between a radiation ray detector (26) for acquiring a transmission image and the object to be inspected is corrected based on an amount of deviation between the characteristic point of the jig (42) photographed on the transmission image and the center of the whole transmission image.

2. An inspection apparatus (100) comprising:

a holding unit (24) formed integrally with a jig (42), configured to fix an object to be inspected;
a detection unit (26) configured to create a transmission image by detecting a radiation ray passing through the object to be inspected or the jig (42); and
a drive unit (18) configured to correct a positional relationship between the object to be inspected and the detection unit (26) for acquiring a transmission image by transferring the holding unit (24) based on an amount of deviation calculated from both a characteristic point of the jig (42) photographed on the transmission image of the jig (42) and the center of the whole transmission image.

3. An inspection apparatus (100) comprising:

a holding unit (24) formed integrally with a jig (42), configured to fix an object to be inspected;
a detection unit (26) configured to create a transmission image by detecting a radiation ray passing through the object to be inspected or the jig (42);
a deviation amount specification unit (36) configured to acquire a transmission image of the jig (42) to specify a characteristic point of the jig (42) photographed on the transmission image, and to calculate an amount of deviation between the characteristic point of the jig (42) photographed on the transmission image and the center of the whole transmission image; and
an imaging control unit (40) configured to correct a positional relationship between the object to be inspected and the detection unit (26) for acquiring a transmission image based on the amount of deviation.

4. The inspection apparatus (100) according to claim 3, wherein
the deviation amount specification unit (36) acquires an inspection schedule to calculate a spare time between inspections, and when the amount of deviation can be calculated within the spare time, the deviation amount specification unit (42) calculates the amount of deviation by acquiring the transmission image of the jig (42).

<div align="center">

**INTERNATIONAL SEARCH REPORT**

</div>

| | International application No. |
|---|---|
| | PCT/JP2010/002320 |

| A. CLASSIFICATION OF SUBJECT MATTER |
|---|
| *G01N23/04*(2006.01)i, *G01B15/00*(2006.01)i |
| According to International Patent Classification (IPC) or to both national classification and IPC |

| B. FIELDS SEARCHED |
|---|
| Minimum documentation searched (classification system followed by classification symbols) |
| G01N23/00-G01N23/227, G01N21/84-G01N21/958, G01B15/00-G01B15/08, A61B6/00-A61B6/14 |
| Documentation searched other than minimum documentation to the extent that such documents are included in the fields searched |
| Jitsuyo Shinan Koho     1922-1996   Jitsuyo Shinan Toroku Koho   1996-2010<br>Kokai Jitsuyo Shinan Koho   1971-2010   Toroku Jitsuyo Shinan Koho   1994-2010 |
| Electronic data base consulted during the international search (name of data base and, where practicable, search terms used) |
| JSTPlus(JDreamII) |

| C. DOCUMENTS CONSIDERED TO BE RELEVANT |

| Category* | Citation of document, with indication, where appropriate, of the relevant passages | Relevant to claim No. |
|---|---|---|
| X | JP 2009-36660 A (Toshiba IT & Control Systems Corp.),<br>19 February 2009 (19.02.2009),<br>paragraphs [0035] to [0043]<br>(Family: none) | 1 |
| X | JP 8-62159 A (Hitachi, Ltd.),<br>08 March 1996 (08.03.1996),<br>paragraphs [0021], [0024] to [0033]<br>(Family: none) | 1-4 |
| A | WO 2009/78415 A1 (Uni-Hite System Corp.),<br>25 June 2009 (25.06.2009),<br>paragraph [0011]; fig. 1, 8<br>(Family: none) | 1-4 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 April, 2010 (16.04.10) | 27 April, 2010 (27.04.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2010/002320

C (Continuation).   DOCUMENTS CONSIDERED TO BE RELEVANT

| Category* | Citation of document, with indication, where appropriate, of the relevant passages | Relevant to claim No. |
|---|---|---|
| A | Atsushi KITAHATA, "Inline 3D-X-sen Kensa System 'BF-X1'", Electronic Packaging Technology, 20 December 2009 (20.12.2009), vol.26, no.1, pages 20 to 23 | 1-4 |

Form PCT/ISA/210 (continuation of second sheet) (July 2009)

EP 2 527 822 A1

### INTERNATIONAL SEARCH REPORT

International application No.

PCT/JP2010/002320

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
   The invention in claim 1 does not have a special technical feature, since the invention is same as the invention described in JP 2009-36660 or JP 8-62159. Furthermore, there is no any claim dependent on claim 1. Therefore, this international application involves two or more inventions including the invention in claim 1 as a main invention.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

14

**EP 2 527 822 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006226875 A